(19) Europäisches Patentamt
European Patent Office
Office européen des brevets

(11) **EP 2 403 135 B1**

(12) **EUROPEAN PATENT SPECIFICATION**

(45) Date of publication and mention
of the grant of the patent:
**11.12.2013 Bulletin 2013/50**

(51) Int Cl.:
*H03F 1/02* (2006.01)  *H03F 1/07* (2006.01)

(21) Application number: **10290342.4**

(22) Date of filing: **24.06.2010**

(54) **Power amplifier for mobile telecommunications**

Leistungsverstärker für mobile Telekommunikation

Amplificateur de puissance pour télécommunication mobile

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(43) Date of publication of application:
**04.01.2012 Bulletin 2012/01**

(73) Proprietor: **Alcatel Lucent
75007 Paris (FR)**

(72) Inventor: **Grebennikov, Andrei
Castleknock, Dublin 15 (IE)**

(74) Representative: **Sarup, David Alexander
Alcatel-Lucent Telecom Ltd
Intellectual Property Business Group
Christchurch Way
Greenwich
London SE10 0AG (GB)**

(56) References cited:
EP-A1- 1 677 414      WO-A1-03/065599
WO-A1-2006/003608      WO-A1-2009/081341
WO-A2-02/054589      US-A1- 2003 141 933

• **ALLEN P E ET AL: "Analysis and Design of a High-Efficiency Multistage Doherty Power Amplifier for Wireless Communications", IEEE TRANSACTIONS ON MICROWAVE THEORY AND TECHNIQUES, IEEE SERVICE CENTER, PISCATAWAY, NJ, US, vol. 53, no. 3, 1 March 2005 (2005-03-01), pages 852-860, XP011128130, ISSN: 0018-9480, DOI: DOI:10.1109/TMTT.2004.842505**
• **YOUNGOO YANG ET AL: "A Fully Matched <maths><tex>$N$</tex></maths>-Way Doherty Amplifier With Optimized Linearity", IEEE TRANSACTIONS ON MICROWAVE THEORY AND TECHNIQUES, IEEE SERVICE CENTER, PISCATAWAY, NJ, US, vol. 51, no. 3, 1 March 2003 (2003-03-01), pages 986-993, XP011076951, ISSN: 0018-9480, DOI: DOI:10.1109/TMTT.2003.808713**

**Description**

Field of the Invention

The present invention relates to a power amplifier employed in mobile telecommunications systems, particularly a power amplifier commonly known as a Doherty amplifier.

Background Art

In mobile telecommunication systems it is required that a power amplifier in a mobile base station should operate with high efficiency and high linearity simultaneously. "Efficiency" is generally regarded as the ratio of RF transmission output power to DC input power. "Linearity" has various measures, but a common measure is ACLR - adjacent channel power leakage ratio. There is a trade off between efficiency and linearity, with improvement in one coming at the expense of another. Many wireless communications systems, such as GSM/EDGE, CDMA2000, or WCDMA/LTE, require that the power amplifier should deliver a wide range of output powers. As a result, being designed for the highest power level with maximum available efficiency, power amplifiers in base stations tend to operate less efficiently at lower power levels consuming a lot of extra dc power. Therefore, there is a challenge to design a base station power amplifier having high efficiency and high linearity not only at maximum output power but also at lower power levels typically ranging from -6 dB and less. It is possible to employ linearization schemes to improve linearity, but these introduce extra complexity.

US Patent No. 2,210,028 to Doherty describes the principle of operation of the Doherty amplifier. A Doherty amplifier includes a main or carrier amplifier, usually biased into class B or AB, with a peak amplifier coupled in parallel and biased into class C, so as to switch on at modulation peaks. This provides a more efficient use of amplifier capability, since the carrier amplifier may be set to provide maximum power efficiency at saturation, backed off by -6 dB from the peak output. When the peaking amplifier switches in at the -6 dB point to increase power to the antenna load, an impedance inverter at the output of the carrier amplifier senses an increase in load impedance and provides an  apparent lower impedance at the carrier amplifier output, thereby increasing power output of the carrier amplifier.

Srirattana et al, "Analysis and Design of a High-Efficiency Multistage Doherty Power Amplifier for Wireless Communications", IEEE Transactions on Microwave Theory and Techniques, Vol. 53, No. 3. March 2005, pp 852- 860, discloses a specific implementation of a three stage Doherty amplifier, wherein the carrier amplifier is set to a maximum efficiency saturation point at -12 dB back off, where a first peaking amplifier is biased to switch in at -12 dB back off. A second peaking amplifier is biased to switch in at -6 dB back off. This may provide maximum efficiency over a 12 dB range.

To counter perceived problems in the architecture of three stage amplifiers, where the carrier amplifier goes into deep current saturation when the first peaking amplifier switches in, WO 2009/081341 to NXP Semiconductors discloses a three stage Doherty amplifier with an alternative architecture.

It is recognised that a four stage Doherty amplifier would have value in mobile telecommunications, since the carrier amplifier may be set to operate at maximum efficiency over a wider range than with three stage amplifiers. However the architectures proposed by Srirattana and NXP above create problems in four stage architectures, as explained in more detail below.

Summary of the Invention

The present invention provides a power amplifier including a main amplifier, and a plurality of peaking amplifiers, each said main amplifier and peaking amplifier having an input and output, wherein said main amplifier and said peaking amplifiers are configured to operate such that said peaking amplifiers switch on sequentially under increase in input power, a power dividing means coupled between a power amplifier input and inputs of said main amplifier and said peaking amplifiers, the outputs of said main amplifier and said peaking amplifiers being coupled through an impedance network to an output node, wherein said main amplifier is coupled to said output node in a first path, which provides an impedance inverting function and which comprises a first impedance inversion means,
characterised in that said power amplifier is a four stage amplifier, said plurality of peaking amplifiers comprising first, second and third peaking amplifiers, wherein said first peaking amplifier is coupled to said output node through a second path, in parallel with said first path, the second path including a first peaking amplifier impedance comprising second and third impedance inversion means in order to provide a resultant non-inverting impedance between the said first peaking amplifier and said output node, and wherein said second peaking amplifier is coupled to a node between said second and third impedance inversion means, and said third peaking amplifier is coupled to said output node.

The impedance between said first peaking amplifier and the output node comprises second and third impedance inversion means in series to provide a resultant non-inverting impedance. The effect of this is to prevent, when the output of the first peaking amplifier is open circuit, an apparent short circuit existing at the output node which might adversely affect operation of the amplifier.

Said second peaking amplifier is connected to a node between said second and third impedance inversion means, so as to be coupled to said output node through said third impedance inverting means; this provides a Doherty configuration of the first and second peaking amplifiers, as will be explained below.

As preferred, said third peaking amplifier is directly connected to said output node, without any impedance inversion means, again providing a Doherty configuration, as explained below.

As preferred said output node is coupled to an amplifier output via a further impedance inversion means, which serves to transform the value of the output load impedance, for the purpose of adjusting impedance values within the amplifier.

To provide an inverting impedance, a ¼ wavelength transmission line stub may be employed, which may easily be implemented in microstrip in an integrated circuit. The input impedance of such a line is $Z^2/R_L$, where Z is the characteristic impedance of the line, and $R_L$ is the load impedance. The characteristic impedances of the various lines that may be employed in the power amplifier are chosen in order to ensure that the power amplifier operates in the desired way. Alternatively, the inverting impedance may be provided by lumped impedances, for example connected in a pi ($\pi$) network.

An embodiment of the invention provides a relatively low maximum ratio of characteristic impedances of transmission lines employed, as low as two. This provides for greater flexibility in construction of the amplifier. Further the output impedance of the main or carrier amplifier may be kept to a reasonable value to ensure high linearity.

An embodiment of the invention comprises a four-way Doherty power amplifier, which provides a high efficiency at maximum and lower output power levels, with a lowest efficiency peak at between -12 dB and -18 dB backoff, this figure depending principally of the relative sizes of the transistors forming the amplifiers (commonly, an amplifier is formed by a single power transistor). Further the Doherty amplifier may easily be implemented into a hybrid or monolithic integrated circuit. When amplifiers are formed from transistors, particularly in integrated circuits, their physical size (principally gate width) may readily be adjusted to give optimum power output. A ratio that may be employed is 1 (carrier amp): 2 (1st peaking amp): 4 (second peaking amp): 8 (3rd peaking amp). In a hybrid implementation, it may be more difficult to provide transistors with the desired power ratio. In practice therefore, it may be preferable to employ transistors all of the same size. This may reduce the range of operation at maximum efficiency to about 12 dB.

In an embodiment of the four-way Doherty amplifier of the invention, with equal transistor sizes, the maximum ratio of characteristic impedances of the transmission line may be only 2 (Z0 = Z01 = 50 Ohm and Z02 = Z03 = 25 Ohm), which is easy to implement in any substrate. In addition, a lowest efficiency peak at -12 dB backoff can be achieved when all three peaking amplifiers are turned off, for transistors of equal size. To provide a high impedance of the peaking amplifiers when they are turned off and to compensate for effect of their output matching elements and phase delays, offset lines may be used in each carrier or peaking amplifying path.

In a more general aspect, the invention provides a N stage power amplifier, where N≥4 and N is an even number, including a main amplifier, and (N-1) peaking amplifiers, each said amplifier having an input and output, a power dividing means coupled between a power amplifier input and inputs of said main amplifier and said peaking amplifiers, the outputs of said main amplifier and said peaking amplifiers being coupled through an impedance network to an output node,
wherein said main amplifier is coupled to said output node through a first impedance inversion means, a first peaking amplifier is coupled to said output node through (N-2) impedance inversion means in order to provide a resultant non-inverting impedance between the said first peaking amplifier and said output node, a second peaking amplifier is coupled to a node between said (N-2) impedance inversion means, and the (N-1) peaking amplifier is coupled to said output node, and wherein said main amplifier and said peaking amplifiers are configured to operate such that peaking amplifiers switch on sequentially under increase in input power.

Brief Description of the Drawings

Preferred embodiments of the invention will now be described, by way of example only, with reference to the accompanying drawings, wherein:

Figure 1(a) and Figure 1(b) are schematic block diagrams of respective N-stage and 3 stage Doherty amplifiers, according to Srirattana referenced above;
Figure 2 is a schematic diagram of efficiencies of different Doherty power amplifier architectures;
Figure 3 is a schematic diagram of characteristic impedances of microstrip versus line width;
Figure 4 is a schematic diagram of a four stage Doherty amplifier;
Figure 5 is a schematic diagram of a four stage Doherty amplifier according to a first embodiment of the invention;
Figure 6 is a schematic diagram of a four stage Doherty amplifier according to a second embodiment of the invention;
Figure 7 is a schematic diagram of an N-stage Doherty amplifier according to a third embodiment of the invention, where N is an even number;

Figures 8(a), 8(b) and 8(c) are schematic diagrams of a quarter wave transmission line, and lumped impedance equivalent circuits; and

Figure 9 is a schematic diagram of a four way Doherty amplifier, according to the architecture of WO 2009/081341 to NXP.

Description of the Preferred Embodiments

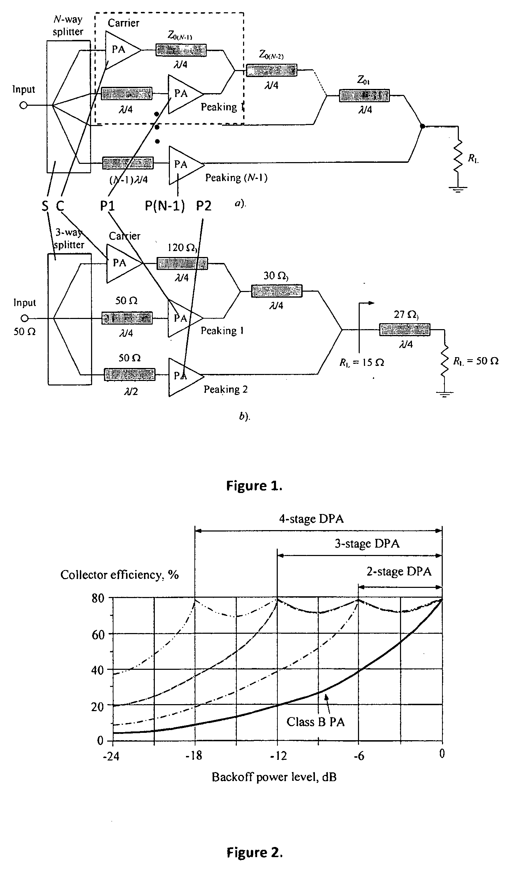

In Figures 1, 4 and 9, similar parts are denoted by the same reference sign.

A multistage Doherty power amplifier architecture according to Srirattana as shown in Fig. 1(a) comprises an input coupled to an N-way power splitter S, with a first path connected to a carrier power amplifier C, and (N-1) paths coupled to peaking amplifiers P1 to P(N-1), each having a transmission line of length $\lambda/4$ to $(N-1)\lambda/4$ in their input line. A chain of (N-1) $\lambda/4$ lines of impedance $Z_{0(N-1)}$ to $Z_{01}$ is coupled between the output of C and a load $R_L$, and the outputs of the peaking amplifiers are coupled to nodes between such impedances, to combine their output powers. It will be noted that this architecture is based on the classic two stage Doherty amplifier, which is exhibited by peaking amplifier P1, connected in parallel with Carrier amplifier C and its output inverting impedance $Z_{0(N-1)}$ - as indicated in dotted lines. As the peaking amplifiers are turned on sequentially, the classic Doherty configuration is again exhibited with the next peaking amplifier due to switch on. In order to maintain phase balance, transmission lines are connected between the N-way splitter and the peaking amplifiers, the lines having a length increasing from $\lambda/4$ to $(N-1)\lambda/4$.

The characteristic impedance of each output quarter wave transmission line depends on the levels of backoff and can be calculated from

$$Z_{0i} = R_L \prod_{j=1}^{i} \gamma_j \qquad (1)$$

$$\prod_{j=k}^{(i+k)/2} \gamma_{(2j-k)} = 10^{(B_i/20)} \qquad (2)$$

where $i = 1, 2, ..., N - 1$, $k = 1$ (for odd $i$) or 2 (for even $i$), $N$ is the total number of amplifier stages, and $B_i$ is the backoff level (positive value in decibels) from maximum output power of the system at which the efficiency will peak. The maximum level of backoff $B_{N-1}$ is set by the carrier amplifier and the number of efficiency peaking points and is directly proportional to the number of amplifier stages used in the design. Figure 2 shows the instantaneous collector efficiencies of the multistage Doherty power amplifier (DPA) architectures for two, three and four stages having maximum efficiency at the transition points of -6 dB, -12 dB and -18 dB backoff output power levels, respectively. From Fig. 2 it follows that a multistage architecture provides significantly higher efficiency at all backoff output power levels compared with the conventional Class B power amplifiers.

A practical case of a three-stage Doherty power amplifier of Srirattana's architecture as shown in Fig. 1(*b*). The characteristic impedances of each output quarter wave transmission line can be found from Eqs. (1) and (2) to be

$$Z_{01} = \gamma_1 R_L \qquad (3)$$

$$Z_{02} = \gamma_1 \gamma_2 R_L \qquad (4)$$

where

$$\gamma_1 = 10^{(B_1/20)} \qquad (5)$$

$$\gamma_2 = 10^{(B_2/20)} \tag{6}$$

where $B_1 = 6$ and $B_2 = 12$ for peak efficiencies at -6 dB and -12 dB backoff, respectively. As a result, $\gamma_1 = 2$ and $\gamma_2 = 4$, with $Z_{02} = 120\ \Omega$, and $Z_{01} = 30\ \Omega$. The maximum ratio between characteristic impedances $Z_{02}/Z_{01} = \gamma_2 = 4$. In Fig. 1(*b*), a further $\lambda/4$ transmission line of 27 $\Omega$ impedance is connected to the power amplifier output, and transforms the output load impedance $R_L$ from 50 $\Omega$ to 15 $\Omega$

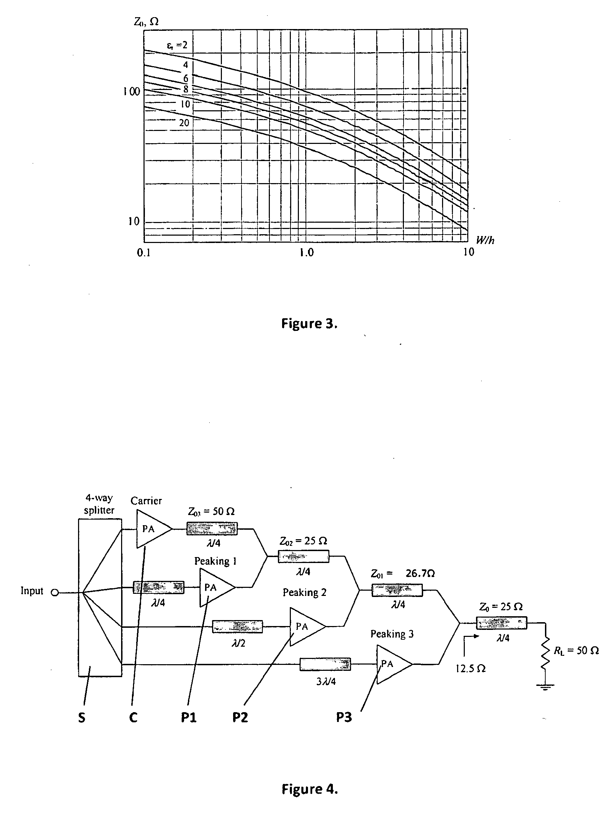

For a four-way Doherty power amplifier of this architecture as shown in Fig. 4, the characteristic impedances of each output quarter wave transmission line can be derived as:

$$Z_{01} = \gamma_1 R_L \tag{7}$$

$$Z_{02} = \gamma_1 \gamma_2 R_L \tag{8}$$

$$Z_{03} = \gamma_1 \gamma_2 \gamma_3 R_L \tag{9}$$

where

$$\gamma_1 = 10^{(B_1/20)} \tag{10}$$

$$\gamma_2 = 10^{(B_2/20)} \tag{11}$$

$$\gamma_3 = 10^{(B_3/20)} \tag{12}$$

where $B_1 = 6$, $B_2 = 12$, $B_3 = 18$ for peak efficiencies at -6 dB, -12 dB and -18 dB backoff, respectively. As a result, $\gamma_1 = 2$ and $\gamma_2 = \gamma_3 = 4$, with the maximum difference between characteristic impedances $Z_{03}$ and $Z_{01}$ equal to $Z_{03}/Z_{01} = \gamma_2\gamma_3 = 16$. For example, for $R_L = 6\ \Omega$, (a 50 $\Omega$ load with a transforming 17 $\Omega$ quarter wave transmission line) the transmission-line characteristic impedances are equal to $Z_{01} = 12\ \Omega$, $Z_{02} = 48\ \Omega$, and $Z_{03} = 192\ \Omega$, respectively. This is impractical to fabricate on a single substrate with fixed thickness microstrip lines, as may be seen from Figure 3, where $W$ is the line width, $h$ is the substrate thickness, and $\varepsilon_r$ is the effective dielectric permittivity. Besides, when all three peaking amplifiers are turned off, the impedance seen by the remaining carrier amplifier is equal to [(192 $\Omega$)$^2$/(48 $\Omega$)$^2$]/[(12 $\Omega$)$^2$/ (6 $\Omega$)] = (48 $\Omega$)$^2$/(6 $\Omega$)= 384 $\Omega$, since generally the impedance at the input of the transmission line with characteristic impedance $Z_0$ is defined as $R_{in} = Z_0^2 / R_L$, where $R_L$ is the impedance loading the transmission line. As a result, the carrier amplifier is operated in deep saturation.

In this case, it is assumed that the physical sizes (gate or emitter widths) of the devices are optimal and related to each other as 1:2:4:8. This leads to linearity degradation over significant range of backoff powers. According to the requirements for base station power amplifiers, ACLR1 and ACLR2 should be better than -45 dB and -50 dB, respectively. Consequently, the closer ACLR values to specification requirements, the easier to improve them by using external digital predistortion linearization scheme. In practice, it is very convenient to use devices with the same size when the devices' periphery ratio is 1:1:1:1 and all PAs are identical, which can provide a better compromise between efficiency, linearity and physical implementation. However, in the case of Figure 4, the maximum backoff efficiency peak then appears only at -8.5 dB backoff instead of -18 dB since (it may be shown) the carrier amplifier C sees impedance of [(50 $\Omega$)$^2$/(25 $\Omega$)$^2$] /[(26.7 $\Omega$)$^2$/(12.5 $\Omega$)] = (33.3 $\Omega$)$^2$/(12.5 $\Omega$)= 89.25 $\Omega$, which is only less than two times greater than the standard 50 $\Omega$.

Note that it can deliver 25% of maximum power (-6 dB) in normal situation when all four amplifiers are turned on, with each PA loaded by the 50-$\Omega$ impedance and resulting in a 12.5 $\Omega$ at the input of the 25 $\Omega$ transmission line connected to the standard 50 $\Omega$ load. And then it needs to add -2.5 dB obtained from the impedance ratio of (89.25 Ohm)/(50 Ohm) = 1.785. Since the output power is defined as $P_{out} = V_{cc}^2/(2R_{out})$ in a conventional Class B mode, this means that, due to higher output resistance seen by the device, the output power will be lower by 1.785 or -10$\times$log1.785 = -2.516 dB, or totally (-6.0 dB) + (-2.5 dB) = -8.5 dB. To get -12 dB, it is necessary to provide an output impedance of 200 Ohm, i.e. four times more.

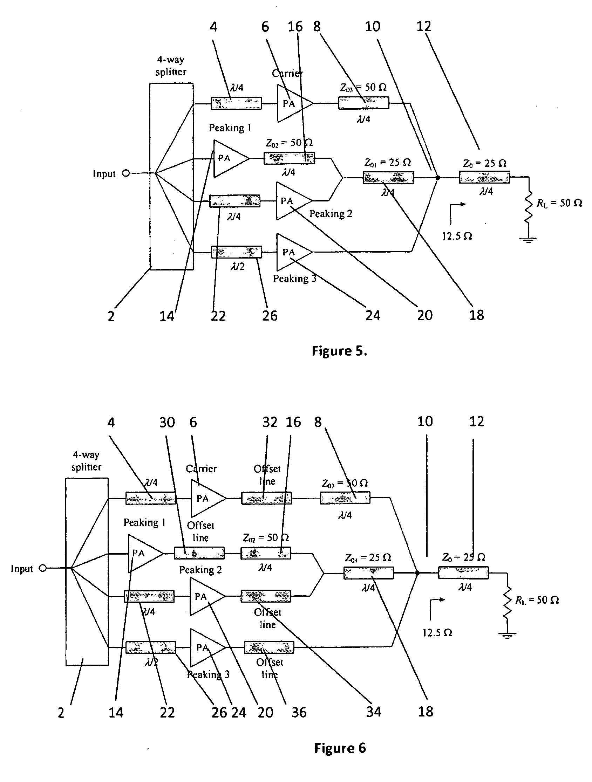

A first embodiment of the invention is shown in the block diagram of Fig. 5. In this four-way Doherty configuration, a 4-way splitter (2) is coupled to the input of carrier amplifier (6) via a $\lambda/4$, rr/2 phase shifting line ($Z_{03}$) (4), and the output of carrier (6) is coupled via a first 50 $\Omega$ $\lambda/4$ line (8) to an output node (10), and the output node is coupled via a 25 $\Omega$ $\lambda/4$ line (12) to load $R_L$. The input of Peaking 1 amplifier (14) is connected directly to the 4-way splitter (2), and the output is connected via a second 50 $\Omega$ $\lambda/4$ line ($Z_{02}$) (16) and a third 25 $\Omega$ $\lambda/4$ line ($Z_{01}$) (18) to output node (10). The input of Peaking 2 amplifier (20) is connected to the 4-way splitter via a $\lambda/4$, $\pi/2$ phase shifting line (22), and the output is connected to the node between line (16) and line (18). The input of Peaking 3 amplifier (24) is connected to the 4-way splitter via a $\lambda/2$, $\pi$ phase shifting line (26), and the output is connected directly to output node (10). The amplifiers are formed by single transistors of equal size.

The operation sequence is as follows, as power output decreases from a maximum, with all amplifiers switched on. The gate bias voltage for the transistor of peaking amplifier 3 (24) is the lowest and it is turned off first, creating ideally open-circuit condition at its output. In this case, the carrier amplifier (6) and peaking amplifier 2 (20) see impedance (50 $\Omega$)$^2$/(37.5 $\Omega$) = 66.7 $\Omega$ instead of 50 $\Omega$, thus operating in saturation (peaking amplifier 1 (14) sees (50 $\Omega$)$^2$/(66.7 $\Omega$) = 37.5 $\Omega$ due to an additional quarter wave line). Then, the peaking amplifier 2 (20) is turned off, creating another efficiency peak since both carrier amplifier (6) and peaking amplifier 1 (14) see (50 $\Omega$)$^2$/(25 $\Omega$) = 75 $\Omega$. Finally, the fourth efficiency peak appears when all peaking amplifiers are turned off and the carrier amplifier (6) sees (50 $\Omega$)$^2$/(12.5 $\Omega$) = 200 $\Omega$.

The maximum ratio between transmission-line characteristic impedances is equal to (50 $\Omega$)/(25 $\Omega$) = 2. The carrier amplifier sees impedance of (50 $\Omega$)$^2$/(12.5 $\Omega$) = 200 $\Omega$, with the output power by (200 $\Omega$)/(50 $\Omega$) = 4, i.e. - 6 dB less compared to the nominal operation for 50 $\Omega$, which means (because the output power is inversely proportional to the load impedance for fixed supply voltage) that peak efficiency appears at backoff of (- 6 dB) + (- 6 dB) = - 12 dB. Peak efficiency at a lower power level may be required, but, for the same size transistors in a practical situation, it can be achieved only at -12 dB in this case, (and only at -8.5 dB for the case of Figure 4). For different device sizes, it will be lower and depend on the device size. For unequal sized transistors, the ratio of impedances of transmission lines is about 5, and there is less flexibility in choice of impedance values.

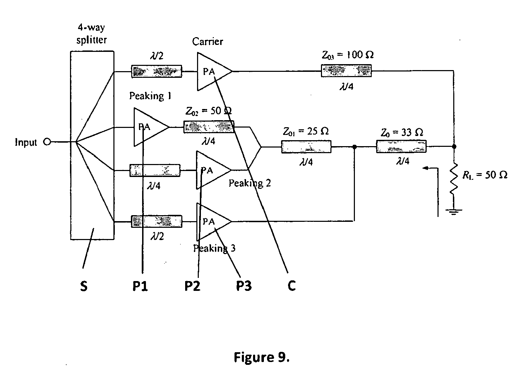

This embodiment may be compared to the unstable operation of the circuit of Figure 9, which is a four stage Doherty amplifier, implemented according to the teachings of WO 2009/081341. In Figure 9, required characteristic impedances of the quarter wave transmission lines range from 25 $\Omega$ to 100 $\Omega$, that is varying by four times, and are as follows: $Z_{03}$ = 100 $\Omega$, $Z_{02}$ = 50 $\Omega$, $Z_{01}$ = 25 $\Omega$, $Z_0$ = 33 $\Omega$. The main problem for this architecture is that it does not work for four stages, and generally for even numbers of stages. For example, when peaking amplifiers P3 and P2 are turned off resulting in open-circuit conditions at their outputs, the number of quarter wave transmission lines between the peaking amplifier P1 and load $R_L$ is equal to 3 (odd number), that is $Z_{02}$, $Z_{01}$ and $Z_0$. In this case, the impedance is infinite (open circuit) at peaking P1 side of the quarter wave lines when peaking P1 is switched off, and zero (short circuit) at the opposite side of the transmission lines, adjacent load $R_L$. This means that the circuit does not work at the third efficiency peak because it is required to have an open-circuit condition from peaking amplifier 1 seen by the load to provide an efficiency peak. In contrast, in the embodiment shown in Figure 5, an open circuit at the output of Peaking 1 amplifier (14), when peaking 2 and 3 amplifiers (20, 24) are turned off creates an open-circuit condition at the end of $Z_{01}$ line (18) due to a half-wave line, composed of two quarter wave lines (16, 18) in series, thus permitting power delivery from the Carrier amplifier (6).

In the arrangement of Figure 5, due to device output parasitics such as the drain-source capacitance, the outputs of the turned-off transistors, constituting the amplifiers in reality, are not perfect open circuits. Therefore, to compensate for these parasitic reactances, an additional equal-length phase offset line (30, 32, 34, 36), which introduces a compensating inductive reactance, is connected in series to each amplifier output circuit, as shown in Fig. 6, which shows a second embodiment of the invention, where similar parts to those of Figure 5 are denoted by the same reference numeral. A phase offset line is a transmission line, typically microstrip, of predetermined length and impedance, which provides a required compensatory phase offset.

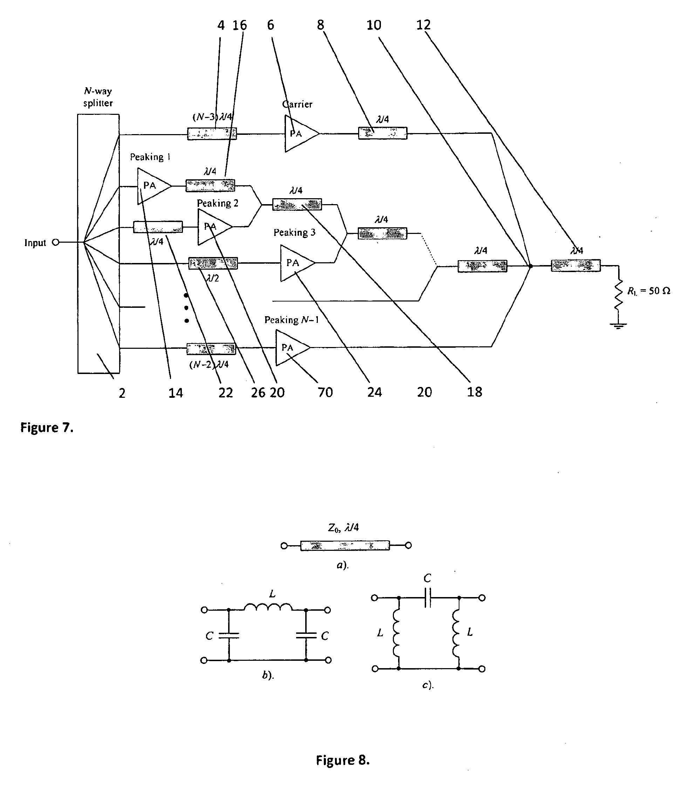

Figure 7 shows a third embodiment of the invention, which is an N-way Doherty amplifier, for $N \geq 4$, where N is an even number, as a generalization of the four-way Doherty power amplifier of Figure 5. Similar parts to those of Fig. 5 are referred to by the same reference number. In Figure 7, the (N-1) peaking amplifier (70) is directly connected to the output node (10). It will be noted that the output of peaking amplifier 1 (14) is connected to node (10) via an even number of quarter wave transmission line stubs. In this case, the number N of stages is even, otherwise an undesirable a short-circuit condition may result.

It may be difficult to implement Doherty power amplifiers employing transmission line stubs in integrated circuits with high level of integration, since the physical size of the quarter wave transmission line stubs is too large. Therefore, an alternative solution in this situation is to replace the transmission lines by lumped impedance elements, as shown in Figure 8. In Figure 8(a), a quarter wave transmission line stub with characteristic impedance $Z_0$ is shown. Figure 8(b) shows an equivalent circuit for the single frequency of operation, comprising a $\pi$ network with two capacitors C connected to the ground line, and an inductance L in the signal path. Figure 8(c) shows an equivalent circuit for the single frequency of operation, comprising a $\pi$ network with two inductors L connected to the ground line, and an capacitor C in the signal path. In this case for angular frequency w, the following relationships between the circuit elements:

$$Z_0 \omega C = \frac{Z_0}{\omega L} = 1. \tag{13}$$

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

**Claims**

1. A power amplifier including a main amplifier (6), and a plurality of peaking amplifiers (14, 20, 24), each said main amplifier and peaking amplifier having an input and output, wherein said main amplifier and said peaking amplifiers are configured to operate such that said peaking amplifiers switch on sequentially under increase in input power, a power dividing means (2) coupled between a power amplifier input and inputs of said main amplifier and said peaking amplifiers, the outputs of said main amplifier and said peaking amplifiers being coupled through an impedance network to an output node (10), wherein said main amplifier is coupled to said output node in a first path, which provides an impedance inverting function and which comprises a first impedance inversion means (8), **characterised in that** said power amplifier is a four stage amplifier, said plurality of peaking amplifiers comprising first (14), second (22) and third peaking amplifiers (24), wherein said first peaking amplifier is coupled to said output node through a second path, in parallel with said first path, the second path including a first peaking amplifier impedance comprising second (16) and third impedance inversion means (18) in order to provide a resultant non-inverting impedance between the said first peaking amplifier and said output node, and wherein said second peaking amplifier is coupled to a node between said second and third impedance inversion means, and said third peaking amplifier is coupled to said output node.

2. A power amplifier according to claim 1, wherein said output node is coupled to a power amplifier output via a further impedance inversion means (12), which serves to transform the value of the output load impedance.

3. A power amplifier according to claim 2, wherein said impedance inversion means are implemented as transmission line stubs, and the maximum ratio of characteristic impedances of said transmission line stubs is about 2.

4. A power amplifier according to claim 3, wherein said carrier and peaking amplifiers are implemented as transistors, which are of equal size.

5. A power amplifier according to claim 2, wherein said impedance inversion means are implemented as transmission line stubs, the maximum ratio of characteristic impedances of said transmission line stubs is about 5, and wherein said carrier and peaking amplifiers are implemented as transistors, and are of different sizes, being in the ratio 1:2:4:8.

6. A power amplifier according to any preceding claim, including one or more phase offset transmission line (30-36) of predetermined length and impedance coupled to respective outputs of one or more of said main and peaking amplifiers.

**Patentansprüche**

1. Leistungsverstärker, welcher einen Hauptverstärker (6) und eine Vielzahl von Spitzenverstärkern (14, 20, 24) umfasst, wobei der besagte Hauptverstärker und die besagten Spitzenverstärker einen Eingang und einen Ausgang aufweisen, wobei der besagte Hauptverstärker und die besagten Spitzenverstärker dafür konfiguriert sind, derart betrieben zu werden, dass die besagten Spitzenverstärker bei ansteigender Eingangsleistung nacheinander eingeschaltet werden,
   wobei ein Leistungsteilungsmittel (2) zwischen einem Eingang des Leistungsverstärkers und Eingängen des besagten Hauptverstärkers und der besagten Spitzenverstärker gekoppelt ist, wobei die Ausgänge des besagten Hauptverstärkers und der besagten Spitzenverstärker über ein Impedanznetzwerk an einen Ausgangsknoten (10) gekoppelt sind, wobei der besagte Hauptverstärker an den besagten Ausgangsknoten in einem ersten Pfad, welcher eine Impedanzinversionsfunktion bereitstellt und ein erstes Impedanzinversionsmittel (8) umfasst, gekoppelt ist, **dadurch gekennzeichnet, dass** der besagte Leistungsverstärker ein vierstufiger Verstärker ist, wobei die besagte Vielzahl von Spitzenverstärkern einen ersten (14), einen zweiten (22) und einen dritten (24) Spitzenverstärker umfasst, wobei der besagte erste Spitzenverstärker über einen zweiten Pfad, welcher parallel zu dem besagten ersten Pfad verläuft, an den besagten Ausgangsknoten gekoppelt ist, wobei der zweite Pfad mit einer ersten Spitzenverstärkerimpedanz ein zweites (16) und ein drittes Impedanzinversionsmittel (18) einschließt, um eine sich daraus ergebende nicht invertierende Impedanz zwischen dem besagten ersten Spitzenverstärker und dem besagten Ausgangsknoten bereitzustellen, und wobei der besagte zweite Spitzenverstärker an einen Knoten zwischen dem besagten zweiten und dem besagten dritten Impedanzinversionsmittel gekoppelt ist, und wobei der besagte dritte Spitzenverstärker an den besagten Ausgangsknoten gekoppelt ist.

2. Leistungsverstärker nach Anspruch 1, wobei der besagte Ausgangsknoten über ein weiteres Impedanzinversionsmittel (12), welches dazu dient, den Wert der Ausgangslastimpedanz zu transformieren, an einen Leistungsverstärkerausgang gekoppelt ist.

3. Leistungsverstärker nach Anspruch 2, wobei die besagten Impedanzinversionsmittel als Übertragungsleitungsstutzen implementiert werden, und wobei das maximale Verhältnis der charakteristischen Impedanzen der besagten Übertragungsleitungsstutzen rund 2 beträgt.

4. Leistungsverstärker nach Anspruch 3, wobei der besagte Trägerfrequenzverstärker und die besagten Spitzenverstärker als Transistoren gleicher Größe implementiert werden.

5. Leistungsverstärker nach Anspruch 2, wobei die besagten Impedanzinversionsmittel als Übertragungsleitungsstutzen implementiert werden, wobei das maximale Verhältnis der charakteristischen Impedanzen der besagten Übertragungsleitungsstutzen rund 5 beträgt, und wobei der besagte Trägerfrequenzverstärker und die besagten Spitzenverstärker als Transistoren implementiert werden und unterschiedliche Größen mit einem Verhältnis von 1:2:4:8 aufweisen.

6. Leistungsverstärker nach einem beliebigen der vorstehenden Ansprüche, umfassend eine oder mehrere phasenversetzte Übertragungsleitungen (30-36) mit vorbestimmter Länge und Impedanz, welche an jeweilige Ausgänge eines oder mehrerer der besagten Haupt- und Spitzenverstärker gekoppelt sind.

**Revendications**

1. Amplificateur de puissance comprenant un amplificateur principal (6), et une pluralité d'amplificateurs de crête (14, 20, 24), chacun parmi lesdits amplificateur principal et amplificateur de crête présentant une entrée et une sortie, ledit amplificateur principal et lesdits amplificateurs de crête étant configurés pour fonctionner de sorte que lesdits amplificateurs de crête se mettent en marche de manière séquentielle lors d'une augmentation de la puissance d'entrée,
   un moyen de division de puissance (2) couplé entre une entrée d'amplificateur de puissance et des entrées dudit amplificateur principal et desdits amplificateurs de crête, les sorties dudit amplificateur principal et desdits amplificateurs de crête étant couplées par l'intermédiaire d'un réseau d'impédance à un noeud de sortie (10), ledit amplificateur principal étant couplé audit noeud de sortie dans un premier chemin, qui fournit une fonction d'inversion d'impédance et qui comprend un premier moyen d'inversion d'impédance (8), **caractérisé en ce que** ledit amplificateur de puissance est un amplificateur à quatre étages, ladite pluralité d'amplificateurs de crête comprenant un premier (14), un deuxième (22) et un troisième amplificateurs de crête (24), ledit premier amplificateur de crête étant couplé audit noeud de sortie par l'intermédiaire d'un deuxième chemin, parallèle audit premier chemin, le deuxième chemin incluant une impédance de premier amplificateur de crête comprenant un deuxième moyen d'inversion d'impédance (16) et un troisième moyen d'inversion d'impédance (18) afin de fournir une impédance de non-inversion résultante entre ledit premier amplificateur de crête et ledit noeud de sortie, et ledit deuxième amplificateur de crête étant couplé à un noeud entre lesdits deuxième et troisième moyens d'inversion d'impédance, et ledit troisième amplificateur de crête est couplé audit noeud de sortie.

2. Amplificateur de puissance selon la revendication 1, dans lequel ledit noeud de sortie est couplé à une sortie d'amplificateur de puissance par l'intermédiaire d'un autre moyen d'inversion d'impédance (12), qui sert à transformer la valeur de l'impédance de charge de sortie.

3. Amplificateur de puissance selon la revendication 2, dans lequel lesdits moyens d'inversion d'impédance sont mis en oeuvre comme des tronçons de ligne de transmission, et le rapport maximum d'impédances caractéristiques desdits tronçons de ligne de transmission est environ de 2.

4. Amplificateur de puissance selon la revendication 3, dans lequel lesdits amplificateurs de porteuse et de crête sont mis en oeuvre comme des transistors, qui sont de taille égale.

5. Amplificateur de puissance selon la revendication 2, dans lequel lesdits moyens d'inversion d'impédance sont mis en oeuvre comme des tronçons de ligne de transmission, le rapport maximum d'impédances caractéristiques desdits tronçons de ligne de transmission est environ de 5, et dans lequel lesdits amplificateurs de porteuse et de crête sont mis en oeuvre comme des transistors, et sont de tailles différentes, dans le rapport 1:2:4:8.

6. Amplificateur de puissance selon l'une quelconque des revendications précédentes, comprenant une ou plusieurs lignes de transmission de déphasage (30 à 36) de longueur et d'impédance prédéterminées couplée(s) à des sorties respectives d'un ou de plusieurs parmi ledit amplificateur principal et lesdits amplificateurs de crête.

**Figure 1.**

**Figure 2.**

Figure 3.

Figure 4.

**Figure 5.**

**Figure 6**

**Figure 7.**

**Figure 8.**

**Figure 9.**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2210028 A

- WO 2009081341 A

**Non-patent literature cited in the description**

- **SRIRATTANA et al.** Analysis and Design of a High-Efficiency Multistage Doherty Power Amplifier for Wireless Communications. *IEEE Transactions on Microwave Theory and Techniques,* March 2005, vol. 53 (3), 852-860